# EUROPÄISCHE PATENTSCHRIFT

(11) **EP 3 870 978 B1**
(45) Veröffentlichungstag und Bekanntmachung des Hinweises auf die Patenterteilung: **13.03.2024**
(21) Anmeldenummer: 18795364.1
(22) Anmeldetag: 22.10.2018
(51) Int. Cl.: G01R 31/00, G01R 1/04, G01R 1/18, G01R 31/28, B60L 3/00, B60L 58/10

(54) **SIGNALERZEUGUNGSVORRICHTUNG UND MESSVORRICHTUNG**
SIGNAL GENERATING DEVICE AND MEASUREMENT DEVICE
DISPOSITIF DE GÉNÉRATION DE SIGNAUX ET DISPOSITIF DE MESURE

(43) Veröffentlichungstag der Anmeldung: 01.09.2021
(73) Patentinhaber: Lisa Dräxlmaier GmbH, 84137 Vilsbiburg (DE)
(72) Erfinder: ZACHERL, Christian, 85461 Bockhorn (DE); KEMPF, Andreas, Füssen 87629 (DE); TODOROV, Vencislav, 1230 Wien (AT); MAYER, Thomas, 84184 Ast (DE)
(86) Internationale Anmeldenummer: PCT/EP2018/078844
(87) Internationale Veröffentlichungsnummer: WO 2020/083459

(56) Entgegenhaltungen:
- DE-A1-102010 045 983
- "Vehicles, boats and internal combustion engines - Radio disturbance characteristics - Limits and methods of measurement for the protection of on-board receivers", CISPR 25:2016, IEC, 3, RUE DE VAREMBÉ, PO BOX 131, CH-1211 GENEVA 20, SWITZERLAND, 27. Oktober 2016 (2016-10-27), Seiten 1-320, XP082004519, [gefunden am 2016-10-27]

## Beschreibung

### Technisches Gebiet

Die vorliegende Erfindung betrifft eine Signalerzeugungsvorrichtung. Ferner betrifft die vorliegende Erfindung eine entsprechende Messvorrichtung.

### Stand der Technik

Die vorliegende Erfindung wird im Folgenden hauptsächlich in Verbindung mit elektrischen Störeinkopplungen in Elektrofahrzeugen beschrieben. Es versteht sich, dass die vorliegende Erfindung aber auch in anderen elektrischen Anwendungen genutzt werden kann.

In modernen Fahrzeugen ist es eines der Entwicklungsziele, den Kraftstoffverbrauch und damit den Schadstoffausstoß zu minimieren. Dies kann z.B. notwendig sein, um entsprechende gesetzliche Anforderungen zu erfüllen.

Neben der Steigerung der Effizienz herkömmlicher Verbrennungsmotoren, werden zur Reduktion des Schadstoffausstoßes auch alternative Antriebskonzepte eingesetzt. In solchen Antriebskonzepten können z.B. Verbrennungsmotoren durch Elektromotoren ergänzt, sog. Hybrid-Fahrzeuge, oder ersetzt, sog. Elektrofahrzeuge, werden.

Der Einsatz starker Elektromotoren im Fahrzeug erfordert eine entsprechende Spannungsversorgung und Regelungselektronik, welche die entsprechenden Spannungen und Ströme verarbeiten kann. Eine elektrischer Antriebsmotor für eine Elektrofahrzeug kann z.B. bei Spannungen von 400 V oder auch mehr als 800 V betrieben werden und es können im System Ströme von mehreren hundert Ampere fließen.

Üblicherweise wird in einem Elektrofahrzeug ein herkömmliches Kleinstspannungsbordnetz, z.B. 12 V, ebenfalls aus der Hochvoltbatterie versorgt. Dazu wird ein DC/DC-Wandler vorgesehen, welcher die Spannung der Hochvoltbatterie auf die entsprechende Nennspannung des Kleinstspannungsbordnetzes wandelt.

Insbesondere das Vorhandensein der hohen Ströme in dem Antriebsstrang kann aber zu Störeinkopplungen in dem Niedervolt- oder Kleinstspannungsbordnetz führen, die es zu vermeiden gilt. In den elektrischen bzw. elektronischen Komponenten der Spannungsversorgung solcher Fahrzeuge werden daher entsprechende Maßnahmen getroffen, um die Störeinkopplungen aus dem Hochspannungsteil des Bordnetzes in den Niederspannungsteil des Bordnetzes zu dämpfen.

In der Entwicklung und auch für die Zulassung eines Fahrzeugs müssen entsprechende Messungen vorgenommen werden, anhand derer die Kopplungsdämpfung bestimmt und überprüft werden kann.

Herkömmliche Messverfahren sind allerdings sehr anfällig für externe Störungen und liefern wenig reproduzierbare Ergebnisse.

Die DE 10 2010 045 983 A1 betrifft ein Verfahren und eine Vorrichtung zum Bestimmen einer Koppeldämpfung einer elektrischen Komponente. Dabei wird ein vorgegebenes Signal in eine erste Spannungsebene der elektrischen Komponente eingespeist und eine Signalantwort in einer zweiten Spannungsebene der elektrischen Komponente gemessen wird. Aus der Signalantwort und dem vorgegebenen Signal wird sodann eine Koppeldämpfung berechnet.

Aus "Vehicles, boats and internal combustion engines - Radio disturbance characteristics - Limits and methods of measurement for the protection of on-board receivers" CISPR 25 Edition 4.0 2016-10; Annex I sind Testmethoden für eine Emissionsmessung von Hochvoltkomponenten elektrisch betriebener Fahrzeuge bekannt.

### Beschreibung der Erfindung

Eine Aufgabe der Erfindung ist es daher, unter Einsatz konstruktiv möglichst einfacher Mittel eine verbesserte Möglichkeit der Koppeldämpfungsmessung in elektrischen Systemen zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Eine erfindungsgemäße Signalerzeugungsvorrichtung zur Erzeugung von Messsignalen für elektrische Systeme weist auf: ein Gehäuse, welches ein elektrisch leitendes Material aufweist, einen Energiespeicher, welcher in dem Gehäuse angeordnet ist, eine Datenschnittstelle, welche an dem Gehäuse angeordnet ist und welche ausgebildet ist, Signaldaten zu empfangen, eine Koppelschnittstelle, welche an dem Gehäuse angeordnet ist und welche mit dem elektrischen System koppelbar ist, und einen Signalgenerator, welcher in dem Gehäuse angeordnet ist und welcher mit dem elektrischen Energiespeicher und der Datenschnittstelle und der Koppelschnittstelle gekoppelt ist, wobei der Signalgenerator ausgebildet ist, basierend auf den Signaldaten die Messignale zu erzeugen und über die Koppelschnittstelle auszugeben.

Eine erfindungsgemäße Messvorrichtung für ein elektrisches System, weist auf: eine Signalerzeugungsvorrichtung gemäß der vorliegenden Erfindung, welche eingangsseitig mit dem elektrischen System gekoppelt ist, und eine Messeinrichtung, welche ausgangsseitig mit dem elektrischen System gekoppelt ist und ausgebildet ist, elektrische Signale in dem elektrischen System zu erfassen.

Unter eingangsseitig ist dabei zu verstehen, dass die Signalerzeugungsvorrichtung mit dem Anschluss bzw. den Anschlüssen des elektrischen Systems gekoppelt wird, über welche die Messsignale eingekoppelt werden sollen. Ausgangsseitig bedeutet, dass die Messeinrichtung mit dem Anschluss bzw. den Anschlüssen des elektrischen Systems gekoppelt wird, an welchen die Messung durchgeführt werden soll.

Die vorliegende Erfindung basiert auf der Erkenntnis, dass bei der Messung der Koppeldämpfung in elektrischen Komponenten eines Fahrzeugs, z.B. in einer entsprechenden Batteriesteuerung (auch Hochvoltschaltbox genannt), die Messtechnik üblicherweise Störungen erzeugt, welche die Messung beeinflussen können. Die bisher gewonnenen Messwerte sind daher wenig reproduzierbar. Beispielsweise können Zuleitungen zu entsprechenden Koppeleinheiten, wie z.B. zu Stromzangen, Störsignale abstrahlen, welche dann von der Messtechnik aufgenommen werden.

Beispielsweise können bisherige Schirmgehäuse über einen externen Generator und eine Koaxialleitung versorgt werden. Zur Unterdrückung von Störungen können Mantelwellensperren eingesetzt werden, die aber nicht über den gesamten Frequenzbereich wirksam sind. Ferner existieren bei diesem Aufbau unterschiedliche Bezugsmassen an den einzelnen Geräten, sowie Leitungslängen der Signalübertragung und die damit einhergehende Abstrahlung der Koaxialkabel, die es verhindern reproduzierbare Messergebnisse zu erzeugen.

Die vorliegende Erfindung sieht daher die Signalerzeugungsvorrichtung vor, die als autonom versorgte und geschirmte Einheit die Erzeugung der Messsignale und deren Übertragung an das zu prüfende elektrische System übernimmt.

Dazu weist die Signalerzeugungsvorrichtung ein Gehäuse aus einem elektrisch leitenden Material auf, z.B. aus Aluminium, (Stahl-)Blech oder dergleichen. Das Gehäuse dient als Aufnahmeraum für die weiteren Komponenten der Signalerzeugungsvorrichtung und schirmt diese gleichzeitig ab, sodass keine Störsignale das Gehäuse verlassen können.

In dem Gehäuse ist ein Energiespeicher angeordnet, welcher der Versorgung der einzelnen Komponenten der Signalerzeugungsvorrichtung dient. Der Energiespeicher kann z.B. eine (aufladbare) Batterie, eine Brennstoffzelle oder dergleichen aufweisen.

Zur Erzeugung der Messsignale ist ein Signalgenerator in dem Gehäuse angeordnet, der über den Energiespeicher mit elektrischer Energie versorgt wird. Die zu erzeugenden Signale können dem Signalgenerator über eine Datenschnittstelle übermittelt werden, welche mit dem Signalgenerator gekoppelt ist. Der Signalgenerator ist ferner mit der Koppelschnittstelle gekoppelt und gibt über diese die erzeugten Messsignale an das elektrische System aus.

Die Signalerzeugungsvorrichtung weist eine Anzahl, also eine oder mehrere, von Lastnachbildungen auf, welche in dem Gehäuse angeordnet sind und welche elektrisch zwischen der Koppelschnittstelle und dem Signalgenerator angeordnet sind.

Die Lastnachbildungen können z.B. auch als Bordnetznachbildungen bezeichnet werden. Die Lastnachbildungen können entsprechende Kapazitäten und Induktivitäten aufweisen, welche für das angeschlossene elektrische System das Vorhandensein eines realen Bordnetzes simulieren. Die Lastnachbildungen können dabei insbesondere die Impedanzen des Bordnetzes im HF/VHF-Bereich nachbilden. Die Lastnachbildungen können dabei z.B. gemäß ISO 7637 oder CISPR 25/ ISO 11452-4 aufgebaut sein. Die Lastnachbildungen können z.B. jeweils eine Induktivität zwischen zwei Lastanschlüssen sowie eine Kapazität zwischen den Lastanschlüssen und Masse aufweisen. Selbstverständlich sind weitere Elemente, wie z.B. Widerstände ebenfalls möglich.

Es versteht sich, dass z.B. für die Messung von Batteriesteuerungen bzw. Hochvoltschaltboxen für jeden Pol der Batteriesteuerungen eine Lastnachbildung vorgesehen sein kann. Bei einer üblichen Hochvoltbatterie können folglich eine Lastnachbildung für den positiven Batteriepol und eine Lastnachbildung für den negativen Batteriepol vorgesehen sein. Es versteht sich, dass für andere Anwendungen mehr oder weniger als zwei Lastnachbildungen vorgesehen werden können.

Die Lastnachbildungen dienen als Schnittstelle zwischen dem Signalgenerator und dem zu prüfenden elektrischen System. Der Signalgenerator ist folglich mit den Lastnachbildungen gekoppelt und speist die erzeugten Messsignale in die Lastnachbildungen ein. Die Lastnachbildungen bilden eine Übertragungsstrecke über welche die Messsignale zur Koppelschnittstelle und von dieser zum zu prüfenden elektrischen System übertragen werden.

Die Lastnachbildungen weisen eingangsseitig, also in Richtung des Signalgenerators, eine erste Eingangsleitung und eine zweite Eingangsleitung auf, wobei die erste Eingangsleitung mit dem Signalgenerator gekoppelt ist und wobei die zweite Eingangsleitung einen Abschlusswiderstand aufweist, wobei die Lastnachbildungen jeweils einen Eingangsschalter aufweisen, welcher ausgebildet ist, jeweils gesteuert die erste Eingangsleitung oder die zweite Eingangsleitung zuzuschalten.

Der Eingangsschalter in den Lastnachbildungen ermöglicht es, auszuwählen, ob die jeweilige Lastnachbildung entweder die empfangenen Messsignale empfängt oder mit einem Abschlusswiderstand von z.B. 50 Ohm (andere Werte ebenfalls möglich) terminiert ist.

Insbesondere bei mehrpoligen Aufbauten kann so z.B. lediglich einer der Pole des elektrischen Systems mit einem Messsignal beaufschlagt werden. Werden Fahrzeugbatterien bzw. die entsprechenden Steuergeräte oder Leistungssysteme einem Test unterzogen, kann z.B. lediglich der positive oder negative Pol des jeweiligen Systems mit den Messsignalen beaufschlagt werden, während der zweite Pol korrekt abgeschlossen werden kann.

Es versteht sich, dass der Eingangsschalter oder Wahlschalter manuell angesteuert werden kann und z.B. vor dem Beginn einer Messung entsprechend eingestellt werden kann. Dazu kann z.B. das Gehäuse geöffnet werden und nach dem Einstellen des Eingangsschalters wieder geschlossen (z.B. verschraubt werden).

Alternativ kann der Eingangsschalter auch elektronisch angesteuert werden. Entsprechende Steuersignale können z.B. über die Datenschnittstelle oder eine separate Steuerschnittstelle an den Eingangsschalter übertragen werden.

Es versteht sich, dass der Eingangsschalter in der jeweiligen Lastnachbildung angeordnet sein kann aber auch als separates Element in dem Gehäuse angeordnet werden kann.

Die vorliegende Erfindung bündelt alle relevanten Komponenten der Signalerzeugungsvorrichtung innerhalb des Gehäuses und versorgt diese autark mit elektrischer Energie zu deren Betrieb. Störsignale, die beispielsweise durch den Signalgenerator erzeugt werden, werden folglich innerhalb des Gehäuses abgeschirmt und können dieses nicht verlassen.

Werden an dem elektrischen System entsprechende Messungen durchgeführt, werden diese folglich nicht durch Störabstrahlungen der Signalerzeugungskette beeinträchtigt.

Mit dem Aufbau der Signalerzeugungsvorrichtung gemäß der vorliegenden Erfindung wird eine Möglichkeit bereitgestellt, Messsignale - insbesondere zu Messung der Koppeldämpfung in elektrischen Systemen von Elektrofahrzeugen - mit nur minimalen ausgesendeten Störungen zu erzeugen. Folglich kann die Messgenauigkeit und damit auch die Reproduzierbarkeit der Messungen erhöht werden.

Weitere Ausführungsformen und Weiterbildungen ergeben sich aus den Unteransprüchen sowie aus der Beschreibung unter Bezugnahme auf die Figuren.

In einer Ausführungsform kann die Signalerzeugungsvorrichtung jeweils eine Stromzange für jede der Lastnachbildungen aufweisen, wobei die Stromzangen um die jeweilige erste Eingangsleitung angeordnet sein können und wobei der Signalgenerator mit den Stromzangen gekoppelt sein kann, um das entsprechende Messsignal in die jeweilige Eingangsleitung einzukoppeln.

Stromzangen haben den Vorteil, dass die Messsignale in die ersten Eingangsleitungen ohne einen Impedanzsprung eingespeist werden können. Folglich können Reflektionen an dem Einspeisepunkt vermieden werden, welche sonst zu Störaussendungen führen könnten.

Es versteht sich, dass je nach Anwendung auch eine kontaktbehaftete Kopplung zwischen dem Signalgenerator und den ersten Eingangsleitungen möglich ist. Beispielsweise kann der Signalgenerator über eine Leitung direkt mit den ersten Eingangsleitungen gekoppelt werden.

In einer weiteren Ausführungsform kann die Signalerzeugungsvorrichtung eine Kalibriereinheit aufweisen, welche mit den Lastnachbildungen und dem Signalgenerator gekoppelt sein kann und welche ausgebildet sein kann, in dem Signalgenerator einen Signalpegel für das jeweilige Messsignal derart einzustellen, dass sich in der entsprechenden Lastnachbildung ein vorgegebener Sollpegel einstellt.

Da die Signalübertragung kontaktlos, also über die Stromzangen erfolgt, können sich auf Grund entsprechender Streuungen in den Lastnachbildungen unterschiedliche Signalpegel einstellen. Um die Genauigkeit bei der Erzeugung der Messsignale zu erhöhen, kann daher die Kalibriereinheit vorgesehen werden. Die Kalibriereinheit dient dazu, sicherzustellen, dass sich in allen Lastnachbildungen die entsprechenden Sollpegel, z.B. von 50 dBµV, einstellen. Dazu kann die Kalibriereinheit die Ausgangspegel des Signalgenerators für die Messsignale einstellen, also erhöhen oder senken, bis sich in den Lastnachbildungen die Sollpegel einstellen. Die Kalibriereinheit kann dazu z.B. mit entsprechenden einstellbaren Verstärkern oder Spannungsquellen in dem Signalgenerator gekoppelt sein und diese entsprechend einstellen.

Es versteht sich, dass die Kalibriereinheit ausgebildet sein kann, dem Signalgenerator ein entsprechendes Kalibriersignal zuzuführen oder diesen anzusteuern, sodass er ein entsprechendes Kalibriersignal erzeugt.

Es versteht sich, dass die Kalibrierung auch einmalig, z.B. bei der Produktion der Signalerzeugungsvorrichtung erfolgen kann. Für eine solche Kalibrierung können entsprechende Messanschlüsse an den Lastnachbildungen vorgesehen werden, welche die Pegelmessung innerhalb der Lastnachbildungen ermöglichen. Die Kalibriereinheit kann ebenfalls über solche Messanschlüsse mit den Lastnachbildungen gekoppelt sein.

In noch einer Ausführungsform kann die Signalerzeugungsvorrichtung eine Schaltvorrichtung aufweisen, welche zwischen Signalausgängen des Signalgenerators und den Lastnachbildungen angeordnet sein kann, wobei die Schaltvorrichtung ausgebildet sein kann, gesteuert die Signalausgänge mit den Lastnachbildungen zu koppeln.

Die Schaltvorrichtung, bzw. auch Schaltmatrix genannt, dient der dynamischen Konfiguration der Signalerzeugungsvorrichtung im Betrieb. Dabei kann die Schaltvorrichtung z.B. ausgebildet sein, jeweils einen Signalausgang des Signalgenerators mit einer entsprechenden Lastnachbildung zu koppeln oder von dieser zu trennen. Die Schaltvorrichtung kann aber auch ausgebildet sein, beliebige der Signalausgänge mit beliebigen Lastnachbildungen zu koppeln. Eine entsprechende Schaltermatrix mit elektronischen oder elektromechanischen Schaltern, wie z.B. Transistoren oder Relais, kann dazu in der Schaltermatrix vorgesehen sein.

Werden Stromzangen zur Einkopplung der Messsignale genutzt, versteht sich, dass die Schaltmatrix zwischen dem Signalgenerator und den Stromzangen angeordnet ist und die Ausgänge der Schaltmatrix jeweils mit einer der Stromzangen gekoppelt sind.

In noch einer Ausführungsform kann das Gehäuse zwei Kammern aufweisen, welche durch eine elektrisch leitende Wand voneinander getrennt sind, wobei in der ersten Kammer der Energiespeicher und der Signalgenerator angeordnet sein können, und wobei in der zweiten Kammer die Koppelschnittstelle angeordnet sein kann.

Durch die Aufteilung in zwei Kammern wird es möglich, diejenigen Elemente, welche Störungen erzeugen in einer der Kammern anzuordnen und die Signaleinspeisung in der zweiten Kammer vorzunehmen. Da die zwei Kammern durch eine elektrisch leitende Wand voneinander getrennt sind, werden die Störungen aus der ersten Kammer nicht direkt in die zweite Kammer übertragen.

Es versteht sich, dass Leitungen von der ersten Kammer in die zweite Kammer gelegt werden können, um die Messsignale zu übertragen. Die Übertragung der Störungen durch diese Leitungen wird aber effektiv unterbunden bzw. gemindert, da durch die geometrische Anordnung der zwei Kammern in dem Gehäuse die Leitungslängen minimiert werden können.

In einer weiteren Ausführungsform kann die Schaltvorrichtung in der ersten Kammer angeordnet sein. Ferner können die Lastnachbildungen und die Stromzangen in der zweiten Kammer angeordnet sein.

Wie oben bereits erläutert, ist es möglich, diejenigen Elemente, welche Störungen erzeugen bzw. abstrahlen in einer der ersten Kammern anzuordnen und die anderen Elemente in der zweiten Kammer anzuordnen, um die Störabstrahlungen in das elektrische System zu minimieren.

In noch einer Ausführungsform kann in der zweiten Kammer eine Anzahl, also eine oder mehrere, entfernbarer elektrisch leitender Wände vorgesehen sein. Die Lastnachbildungen können daher jeweils durch eine der entfernbaren elektrisch leitenden Wände voneinander getrennt sein.

Durch die entfernbaren elektrisch leitenden Wände werden die einzelnen Lastnachbildungen gegeneinander in einzelnen Kammern abgeschirmt. Es wird dadurch möglich, jede der Lastnachbildungen mit einem eigenen Messsignal zu versorgen, ohne dass sich die einzelnen Messsignale gegenseitig beeinflussen.

Es kann aber z.B. auch eine Messung durchgeführt werden, bei welcher ein einzelnes Messsignal zwei Lastnachbildungen zugeführt werden soll. Dazu kann die entsprechende entfernbare elektrisch leitende Wand entfernt werden und eine Stromzange über die zwei entsprechenden ersten Eingangsleitungen gelegt werden. Auf diese Art kann sichergestellt werden, dass beide ersten Eingangsleitungen mit identischen Signalen beaufschlagt werden.

Es versteht sich, dass alternativ die Schaltvorrichtung ausgebildet sein kann, ein einzelnes Eingangssignal zu vervielfältigen und an zwei oder mehr Ausgängen auszugeben.

In einer Ausführungsform kann das Gehäuse eine erste Schale aufweisen, welche die erste Kammer bildet. Ferner kann das Gehäuse eine zweite Schale aufweisen, welche die zweite Kammer bildet. Die zweite Schale kann die erste Kammer in einem montierten Zustand verschließen und ein Deckel kann für die zweite Kammer vorgesehen sein.

Es versteht sich, dass alternativ auch die erste Schale die zweite Kammer bilden kann und dass die zweite Schale die erste Kammer bilden kann.

Die zwei Schalen können z.B. miteinander verschraubt, verklebt oder verschweißt werden. Der Deckel für die zweite Schale kann ebenfalls verschraubt, verklebt oder verschweißt werden. Allerdings ist ein Verschrauben insbesondere dann vorteilhaft, wenn Zugriff auf die zweite Kammer gewünscht ist, z.B. um Trennwände zu entfernen.

Die Schalen können z.B. eine rechteckige oder quadratische Grundfläche aufweisen. Die Höhe der Wände kann an die Elemente angepasst sein, die in der jeweiligen Kammer angeordnet werden sollen.

Die Schalen ermögliche eine sehr einfache Montage der einzelnen Elemente der Signalerzeugungsvorrichtung. Die Montage der gesamten Signalerzeugungsvorrichtung gestaltet sich mit den Schalen folglich sehr einfach.

In einer weiteren Ausführungsform kann das Gehäuse eine Öffnung aufweisen, welche ausgebildet sein kann, den Zugriff auf den Energiespeicher zu ermöglichen, wobei eine entfernbare elektrisch leitende Abdeckung vorgesehen sein kann, welche ausgebildet ist, die Öffnung zu verschließen.

Wie oben bereits erläutert, kann der Energiespeicher z.B. Batterien aufweisen. Folglich müssen diese Batterien regelmäßig getauscht oder aufgeladen werden. Durch die Öffnung kann dieses Tauschen oder Laden erfolgen. Die Abdeckung stellt sicher, dass im Betrieb keine Störabstrahlungen durch die Öffnung austreten.

Es versteht sich, dass die Abdeckung z.B. mit der Gehäusewand verschraubt werden kann. Andere Befestigungsarten, wie z.B. Klemmen, sind ebenfalls möglich.

In noch einer Ausführungsform kann das Gehäuse eine Lüftungsöffnung aufweisen, in welcher ein Wabenkamin angeordnet sein kann, wobei die Lüftungsöffnung insbesondere derart angeordnet sein kann, dass ein Luftstrom zu dem Signalgenerator ermöglicht wird.

Der Signalgenerator ist ein Bauteil welches z.B. Verstärker und andere aktive Elemente aufweisen kann. Die Verlustleistung des Signalgenerators kann also zu einer erheblichen Erwärmung führen. Übliche Signalgeneratoren können ca. 50 W - 60 W Verlustleistung erzeugen. Die Lüftungsöffnung ermöglicht folglich eine Abfuhr der in dem Gehäuse entstehenden Wärme.

Durch den Wabenkamin wird sichergestellt, dass keine Störungen das Gehäuse verlassen bzw. abgestrahlt werden.

In einer Ausführungsform kann die Datenschnittstelle als lichtbasierte Schnittstelle ausgebildet sein. Zusätzlich oder alternativ kann die Koppelschnittstelle als elektrische Schnittstelle, insbesondere als leitungsbasierte Schnittstelle ausgebildet sein.

Die Datenschnittstelle kann z.B. eine Lichtwellenleiter-Schnittstelle sein. In der Gehäusewand können entsprechende Stecker bzw. Buchsen vorgesehen werden. Alternativ kann z.B. auch eine kontaktlose Schnittstelle, z.B. eine Infrarot-Schnittstelle oder dergleichen genutzt werden. In der Gehäusewand können entsprechende Öffnungen vorgesehen sein. Es versteht sich, dass die Öffnungen entsprechende Dimensionen und/oder Abschirmmaßnahmen aufweisen können, sodass ein Ausstrahlen von Störungen durch diese Öffnungen vermieden wird. Der Signalgenerator kann entsprechende Elemente, also z.B. Transceiver, zur Kommunikation über die Datenschnittstelle aufweisen.

Es versteht sich, dass die Datenschnittstelle eine reine Steuerschnittstelle sein kann, über welche Parameter für die Signalerzeugung übertragen werden können. Das bedeutet, dass der Signalgenerator eine entsprechende Steuerlogik aufweisen kann, welche die Parameter auswertet und entsprechende Messsignale erzeugt. Alternativ können über die Datenschnittstelle die Signalformen bzw. Wellenformen übertragen werden, die dann in dem Signalgenerator lediglich verstärkt bzw. angepasst werden, um sie an das elektrische System zu übertragen.

Ferner kann eine Verteilung der Signale der Datenschnittstelle vorgesehen sein. Dadurch wird es möglich z.B. auch die Schaltvorrichtung über die Datenschnittstelle zu steuern.

Beispielsweise kann die Datenschnittstelle als glasfaserbasierte Ethernetschnittstelle ausgebildet sein. Die Verteilung in dem Gehäuse kann dann z.B. durch einen entsprechenden Switch erfolgen. Es versteht sich, dass der Switch auch eine Umsetzung auf ein kupferbasiertes Ethernet vornehmen kann, welches zur internen Kommunikation in der Signalerzeugungsvorrichtung genutzt werden kann.

Da die Koppelschnittstelle die Messsignale an das elektrische System überträgt, ist diese üblicherweise als eine leitungsbasierte Schnittstelle ausgebildet.

In einer weiteren Ausführungsform kann die Signalerzeugungsvorrichtung ausgebildet sein, mit einer Hochvoltseite des elektrischen Systems gekoppelt zu werden. Ferner kann die Messeinrichtung ausgebildet sein, mit einer Niedervoltseite des elektrischen Systems gekoppelt zu werden, wobei die Messeinrichtung insbesondere eine Niedervolt-Lastnachbildung aufweisen kann.

Bei der Messung des Koppeldämpfungsfaktors in elektrischen Systemen für Elektrofahrzeuge werden üblicherweise die Hochvoltschaltboxen vermessen, die einen Hochvoltanschluss für das Hochvoltbordnetz, üblicherweise mehrere hundert Volt, und einen Niedervoltanschluss für das Niedervoltbordnetz, üblicherweise wenige Volt, z.B. 12 V, aufweisen.

Wie oben bereits erläutert, kann die Signalerzeugungsvorrichtung eine entsprechende Bordnetznachbildung für die Hochvoltseite aufweisen. Die Messeinrichtung kann dementsprechend eine Bordnetznachbildung für die Niedervoltseite aufweisen.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: ein Blockschaltbild eines Ausführungsbeispiels einer Signalerzeugungsvorrichtung gemäß der vorliegenden Erfindung;
- Figur 2: ein Blockschaltbild eines weiteren Ausführungsbeispiels einer Signalerzeugungsvorrichtung gemäß der vorliegenden Erfindung;
- Figur 3: eine perspektivische Ansicht eines Ausführungsbeispiels einer Signalerzeugungsvorrichtung gemäß der vorliegenden Erfindung; und
- Figur 4: ein Blockschaltbild eines Ausführungsbeispiels einer Messvorrichtung gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

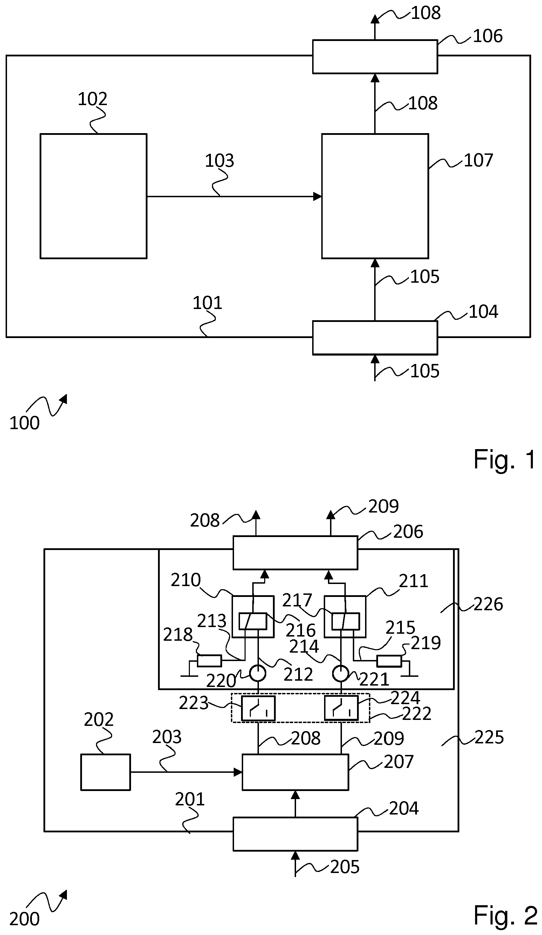

Figur 1 zeigt ein Blockschaltbild einer Signalerzeugungsvorrichtung 100. Die Signalerzeugungsvorrichtung 100 weist ein Gehäuse 101 auf. In dem Gehäuse 101 ist ein Energiespeicher 102 angeordnet, der mit einem Signalgenerator 107 in dem Gehäuse 101 gekoppelt ist. Der Signalgenerator 107 ist ferner mit einer Datenschnittstelle 104 und mit einer Koppelschnittstelle 106 gekoppelt. Um elektrische Störaussendungen zu minimieren, weist das Gehäuse 101 ein elektrisch leitendes Material auf. Ferner kann das Gehäuse 101 je nach Anwendung geerdet sein. Bei der Signalerzeugungsvorrichtung 100 sind alle Elemente, welche Störungen aussenden können in dem Gehäuse 101 angeordnet, um die Messung an dem elektrischen System nicht zu beeinflussen.

Der Energiespeicher 102 kann z.B. eine Batterie sein. Es versteht sich, dass der Energiespeicher 102 neben dem Signalgenerator 107 auch weitere Elemente der Signalerzeugungsvorrichtung 100 mit elektrischer Energie versorgen kann und diesen eine entsprechende Versorgungsspannung 103 bereitstellen kann.

Der Signalgenerator 107 empfängt über die Datenschnittstelle 104 die Signaldaten 105. Die Signaldaten 105 können z.B. Parameter enthalten, anhand derer der Signalgenerator 107 Messsignale 108 zur Einspeisung in das zu vermessende elektrische System erzeugen kann. Alternativ können die Signaldaten 105 auch eine Wellenform aufweisen, welche von dem Signalgenerator 107 lediglich verstärkt bzw. entsprechend angepasst wird. Die erzeugten Messsignale 108 gibt der Signalgenerator 107 über die Koppelschnittstelle 106 aus.

Um eine Beeinflussung der Messung durch die Bereitstellung der Signaldaten 105 zu vermeiden, kann die Datenschnittstelle 104 als nicht-elektromagnetische Schnittstelle, also z.B. als optische Schnittstelle ausgebildet sein, die Lichtwellenleiter zur Datenübertragung nutzt. Beispielsweise kann ein Lichtwellenleiter-basiertes Ethernet genutzt werden.

Die Koppelschnittstelle 106 dagegen dient der Übertragung der Messsignale 108 in das elektrische System. Die Messsignale 108 müssen dabei eine vorgegebene Leistung aufweisen, welche üblicherweise durch entsprechende Prüfstandards festgelegt wird. Folglich ist die Koppelschnittstelle 106 eine leitungsbasierte Schnittstelle, bei welcher die Signale über elektrisch leitende Leitungen an das elektrische System übertragen werden.

Figur 2 zeigt ein Blockschaltbild einer Signalerzeugungsvorrichtung 200. Die Signalerzeugungsvorrichtung 200 basiert auf der Signalerzeugungsvorrichtung 100 und weist folglich ebenfalls ein Gehäuse 201 auf, in dem ein Energiespeicher 202 angeordnet ist, der mit dem Signalgenerator 207 in dem Gehäuse 201 gekoppelt ist. Der Signalgenerator 207 ist ferner mit einer Datenschnittstelle 204 und mit einer Koppelschnittstelle 206 gekoppelt. Das oben zu der Datenschnittstelle 104 und der Koppelschnittstelle 106 gesagte, gilt analog.

In der Signalerzeugungsvorrichtung 200 erzeugt der Signalgenerator 207 zwei Messsignale 208, 209. Die zwei Messsignale 208, 209 sind für jeweils einen Pol eines zweipoligen elektrischen Systems vorgesehen. Ein solches elektrisches System kann z.B. eine Hochvoltschaltbox einer Fahrzeugbatterie mit einem Pluspol und einem Minuspol sein.

Die Signalerzeugungsvorrichtung 200 weist ferner eine Schaltvorrichtung 222 auf, welche mit dem Signalgenerator 207 gekoppelt ist und lediglich beispielhaft zwei Schalter 223, 224 aufweist. Die Schaltvorrichtung 222 kann die Messsignale 208, 209 gesteuert weiterleiten oder blockieren. Es versteht sich, dass in einer Ausführung die Schaltvorrichtung 222 auch ein einzelnes Messsignal auf einen von mehreren Ausgängen schalten kann. Entsprechende Schalter bzw. eine entsprechende Schaltmatrix kann in der Schaltvorrichtung 222 vorgesehen werden.

Die Ausgänge der Schaltvorrichtung 222 sind jeweils über eine Stromzange 220, 221 mit einer ersten Eingangsleitung 212, 214 einer Lastnachbildung 210, 211 gekoppelt. Die Messsignale 208, 209 werden also über die Stromzangen 220, 221 an die jeweilige Lastnachbildung 210, 211 übertragen. Die Lastnachbildungen 210, 211 sind ausgangsseitig mit der Koppelschnittstelle 206 verbunden, um die Messsignale 208, 209 an das elektrische System zu übertragen. Die Lastnachbildungen 210, 211 können, wie oben bereits erläutert, die Impedanzen z.B. eines Fahrzeugbordnetzes im HF/VHF-Bereich nachbilden.

Jede Lastnachbildung 210, 211 weist einen Eingangsschalter 216, 217 auf, der gesteuert die jeweilige erste Eingangsleitung 212, 214 oder jeweils eine zweite Eingangsleitung 213, 215 als Eingang der entsprechenden Lastnachbildung 210, 211 auswählt. Die zweiten Eingangsleitungen 213, 215 sind jeweils mit einem Widerstand 218, 219 abgeschlossen.

Über die Schaltvorrichtung 222 und die Eingangsschalter 216, 217 kann folglich sehr flexibel ausgewählt bzw. eingestellt werden, welches der Messsignale 208, 209 über welche Lastnachbildung 210, 211 an das elektrische System übermittelt werden.

Obwohl der Übersichtlichkeit halber nicht explizit dargestellt, kann eine Kalibriereinheit vorgesehen sein. Die Kalibriereinheit kann mit den Lastnachbildungen 210, 211 und dem Signalgenerator 207 gekoppelt sein. Zum Kalibrieren der Signalpegel für die Stromzangen 220, 221 kann die Kalibriereinheit in dem Signalgenerator 207 einen Signalpegel für das jeweilige Messsignal 208 derart einstellen, dass sich in der entsprechenden Lastnachbildung 210, 211 ein vorgegebener Sollpegel einstellt.

In der Signalerzeugungsvorrichtung 200 sind zwei Kammern 225, 226 vorgesehen. In der ersten Kammer 225 sind der Energiespeicher 202, der Signalgenerator 207 und die Schaltvorrichtung 222 angeordnet. In der zweiten Kammer sind die Stromzangen 220, 221 mit den Lastnachbildungen 210, 211 und den Widerständen 218. 219 angeordnet. Durch diese Anordnung in den Kammern 225, 226 werden diejenigen Elemente, welche Störungen erzeugen von denjenigen Elementen getrennt, welche der Signalübertragung an das elektrische System dienen.

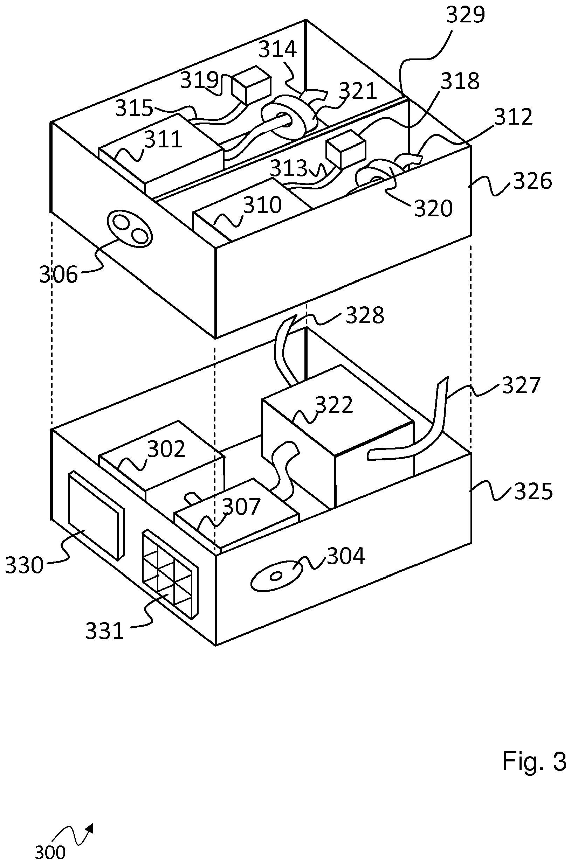

Figur 3 zeigt eine perspektivische Ansicht einer Signalerzeugungsvorrichtung 300. Die Signalerzeugungsvorrichtung 300 ist vereinfacht dargestellt, es versteht sich, dass die Signalerzeugungsvorrichtung 300 jedes der oben und in den Ansprüchen genannten Elemente aufweisen kann.

Die Signalerzeugungsvorrichtung 300 weist eine erste Kammer 325 und eine zweite Kammer 326 auf, welche gemeinsam das Gehäuse bilden. Die Kammern 325, 326 sind jeweils als eine Art Schale oder Kasten aufgebaut. Die zweite Kammer 326 kann auf der ersten Kammer 325 derart montiert werden, dass sie die erste Kammer 325 als eine Art Deckel verschließt. Ferner kann ein Deckel (nicht separat dargestellt) für die zweite Kammer 326 vorgesehen sein. Die erste Kammer 325 und die zweite Kammer 326 können z.B. miteinander verschraubt werden. In der zweiten Kammer 326 ist ferner eine Trennwand 329 vorgesehen, welche die zweite Kammer 326 in zwei einzelne Parzellen unterteilt. Die Trennwand 329 kann lösbar in der zweiten Kammer 326 angeordnet sein.

In der ersten Kammer 325 sind der Energiespeicher 302, der Signalgenerator 307 und die Schaltvorrichtung 322 angeordnet. Um einen Zugriff auf den Energiespeicher 302 zu ermöglichen, ist eine Öffnung in der Seitenwand der Kammer 325 an der entsprechenden Stelle vorgesehen, die von einer lösbaren Abdeckung 330 verschlossen wird. Ferner ist an der entsprechenden Stelle der Seitenwand der Kammer 325 ein Wabenkamin 331 vorgesehen, der der Belüftung des Signalgenerators 307 dient.

Die Schaltvorrichtung 322 ist über zwei Leitungen 327, 328 mit der zweiten Kammer 326 gekoppelt. In der zweiten Kammer 326 ist in jeder Parzelle eine Lastnachbildung 310, 311 vorgesehen. Jede Lastnachbildung 310, 311 weist eine erste Eingangsleitung 312, 314 und ein zweite Eingangsleitung 313, 315 auf. An den ersten erste Eingangsleitungen 312, 314 ist jeweils eine Stromzange 320, 321 vorgesehen. Die Stromzangen 320, 321 werden über die Leitungen 327, 328 mit den jeweiligen Messsignalen gespeist. Die zweiten Eingangsleitungen 313, 315 sind mit Widerständen 318, 319, z.B. mit einem Wert von 50 Ohm, abgeschlossen. In den Lastnachbildungen 310, 311 kann jeweils gewählt werden, ob die erste Eingangsleitung 312, 314 oder die zweite Eingangsleitung 313, 315 aktiviert bzw. zugeschaltet wird. Ausgangsseitig sind die Lastnachbildungen 310, 311 mit der Koppelschnittstelle 306 gekoppelt, um das elektrische System zu kontaktieren.

Bei der Signalerzeugungsvorrichtung 300 kann die Trennwand 329 entfernt werden. Dies kann z.B. genutzt werden, um die zwei ersten Eingangsleitungen 312, 314 durch eine einzelne Stromzange zu führen. Dadurch kann das gleiche Messsignal an den zwei Lastnachbildungen 310, 311 angelegt werden.

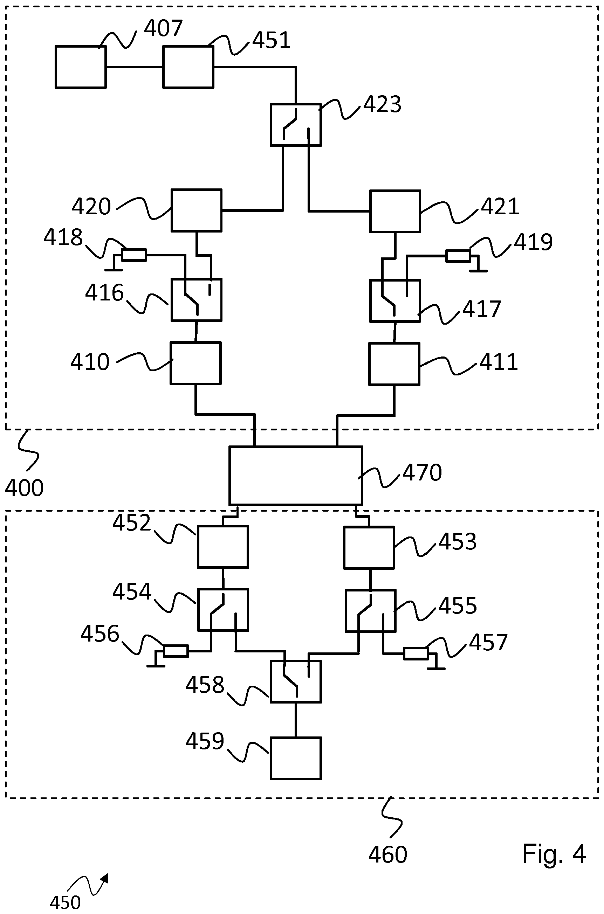

Figur 4 zeigt ein Blockschaltbild einer Messvorrichtung 450. Die Messvorrichtung 450 weist eine Signalerzeugungsvorrichtung 400 auf, die mit einer Hochvoltseite eines elektrischen Systems 470 gekoppelt ist. Auf der Niedervoltseite ist das elektrische System mit einer Messeinrichtung 460 gekoppelt.

Die Signalerzeugungsvorrichtung 400 weist den Signalgenerator 407 auf, der mit einem -3dB Dämpfungsglied 451 gekoppelt ist, um Rückspeisungen in den Signalgenerator 407 zu vermeiden. Das Dämpfungsglied 451 ist mit einem Schalter 423 gekoppelt, der ein Eingangssignal, also ein Messignal, steuerbar auf einen von zwei Ausgängen leitet. Die Ausgänge des Schalters 423 sind jeweils mit einer Stromzange 420, 421 gekoppelt. Die Leitungen die jeweils durch eine der Stromzangen 420, 421 laufen, sind jeweils mit einem Eingangsschalter 416, 417 gekoppelt, welche entweder die entsprechende Leitung oder eine mit einem Widerstand 418, 419 versehen Leitung mit ihrem Ausgang verbinden. Die Eingangsschalter 416, 417 sind an ihren Ausgängen jeweils mit einer Lastnachbildung 410, 411 gekoppelt. Die Lastnachbildungen 410, 411 sind jeweils mit einem Pol der Hochvoltseite des elektrischen Systems 470 verbunden.

Auf der Niedervoltseite sind die zwei Pole des elektrischen Systems 470 jeweils mit einer weiteren Lastnachbildung 452, 453 gekoppelt. Es versteht sich, dass die Lastnachbildungen 452, 453 an die Bedürfnisse der Niedervoltseite angepasst sind, also z.B. für Spannungen von 12 V ausgelegt sind. Die Ausgänge der Lastnachbildungen 452, 453 sind jeweils mit einem Umschalter 454, 455 gekoppelt, welche die Lastnachbildungen 452, 453 entweder mit einem Wiederstand 456, 457 koppeln oder die Lastnachbildungen 452, 453 mit einem Wahlschalter 458 koppeln. Der Ausgang des Wahlschalters 458 ist einem Messempfänger 459 gekoppelt. Es versteht sich, dass der Wahlschalters 458 z.B. auch entfernt werden kann und ein Messempfänger mit mehreren Eingangskanälen genutzt werden kann.

Da es sich bei den vorhergehend detailliert beschriebenen Vorrichtungen um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 100, 200, 300, 400: Signalerzeugungsvorrichtung
- 101, 201: Gehäuse
- 102, 202, 302: Energiespeicher
- 103,203: Versorgungsspannung
- 104, 204, 304: Datenschnittstelle
- 105, 205: Signaldaten
- 106, 206, 306: Koppelschnittstelle
- 107, 207, 307, 407: Signalgenerator
- 108, 208, 209: Messsignal

- 210, 211, 310, 311, 410, 411: Lastnachbildung
- 212, 214, 312, 314: erste Eingangsleitung
- 213, 215, 313, 315: zweite Eingangsleitung
- 216, 217, 416, 417: Eingangsschalter
- 218, 219, 318, 319, 418, 419: Widerstand
- 220, 221, 320, 321, 420, 421: Stromzange
- 222, 322: Schaltvorrichtung
- 223, 224, 423: Schalter
- 225, 226, 325, 326: Kammer

- 327, 328: Leitung
- 329: Trennwand
- 330: Abdeckung
- 331: Wabenkamin

- 450: Messvorrichtung
- 451: Dämpfungsglied
- 452, 453: Lastnachbildung
- 454, 455: Umschalter
- 456, 457: Widerstand
- 458: Wahlschalter
- 459: Messempfänger
- 460: Messeinrichtung

- 470: elektrisches System

## Patentansprüche

1. Signalerzeugungsvorrichtung (100, 200, 300, 400) zur Erzeugung von Messsignalen (108, 208, 209) für elektrische Systeme (470), aufweisend:
a) ein Gehäuse (101, 201), welches ein elektrisch leitendes Material aufweist,
b) einen Energiespeicher (102, 202, 302), welcher in dem Gehäuse (101, 201) angeordnet ist,
c) eine Datenschnittstelle (104, 204, 304), welche an dem Gehäuse (101, 201) angeordnet ist und welche ausgebildet ist, Signaldaten (105, 205) zu empfangen,
d) eine Koppelschnittstelle (106, 206, 306), welche an dem Gehäuse (101, 201) angeordnet ist und welche mit dem elektrischen System (470) koppelbar ist, und
e) einen Signalgenerator (107, 207, 307, 407), welcher in dem Gehäuse (101, 201) angeordnet ist,
wobei die Signalerzeugungsvorrichtung (100,200,300,400) eine Anzahl von Lastnachbildungen (210,211,310,311,410,411) umfasst, welche in dem Gehäuse (101,201) angeordnet sind und welche elektrisch zwischen der Koppelschnittstelle (106,206,306) und dem Signalgenerator (107,207,307,407) angeordnet sind, **dadurch gekennzeichnet, dass**
der Signalgenerator mit dem elektrischen Energiespeicher (102, 202, 302) und der Datenschnittstelle (104, 204, 304) und der Koppelschnittstelle (106, 206, 306) gekoppelt ist, wobei der Signalgenerator (107, 207, 307, 407) ausgebildet ist, basierend auf den Signaldaten (105, 205) die Messignale zu erzeugen und über die Koppelschnittstelle (106, 206, 306) auszugeben,
wobei die Lastnachbildungen (210, 211, 310, 311, 410, 411) eingangsseitig eine erste Eingangsleitung (212, 214) und eine zweite Eingangsleitung (213, 215) aufweisen, wobei die erste Eingangsleitung (212, 214) mit dem Signalgenerator (107, 207, 307, 407) gekoppelt ist und wobei die zweite Eingangsleitung (213, 215) einen Abschlusswiderstand (218, 219, 318, 319, 418, 419) aufweist, wobei die Lastnachbildungen (210, 211, 310, 311, 410, 411) einen Eingangsschalter (216, 217, 416, 417) aufweisen, welcher ausgebildet ist, jeweils gesteuert die erste Eingangsleitung (212, 214) oder die zweite Eingangsleitung (213, 215) zuzuschalten.

2. Signalerzeugungsvorrichtung (100, 200, 300, 400) nach Anspruch 1, mit jeweils einer Stromzange (220, 221, 320, 321, 420, 421) für jede der Lastnachbildungen (210, 211, 310, 311, 410, 411), wobei die Stromzangen (220, 221, 320, 321, 420, 421) um die jeweilige erste Eingangsleitung (212, 214) angeordnet sind und wobei der Signalgenerator (107, 207, 307, 407) mit den Stromzangen (220, 221, 320, 321, 420, 421) gekoppelt ist, um das entsprechende Messsignal (108, 208, 209) in die jeweilige Eingangsleitung (213, 215) einzukoppeln.

3. Signalerzeugungsvorrichtung (100, 200, 300, 400) nach Anspruch 2 mit einer Kalibriereinheit, welche mit den Lastnachbildungen (210, 211, 310, 311, 410, 411) und dem Signalgenerator (107, 207, 307, 407) gekoppelt ist und welche ausgebildet ist, in dem Signalgenerator (107, 207, 307, 407) einen Signalpegel für das jeweilige Messsignal (108, 208, 209) derart einzustellen, dass sich in der entsprechenden Lastnachbildung (210, 211, 310, 311, 410, 411) ein vorgegebener Sollpegel einstellt.

4. Signalerzeugungsvorrichtung (100, 200, 300, 400) nach einem der vorherigen Ansprüche, mit einer Schaltvorrichtung (222), welche zwischen Signalausgängen des Signalgenerators (107, 207, 307, 407) und den Lastnachbildungen (210, 211, 310, 311, 410, 411) angeordnet ist, wobei die Schaltvorrichtung (222) ausgebildet ist, gesteuert die Signalausgänge mit den Lastnachbildungen (210, 211, 310, 311, 410, 411) zu koppeln.

5. Signalerzeugungsvorrichtung (100, 200, 300, 400) nach einem der vorherigen Ansprüche, wobei das Gehäuse (101, 201) zwei Kammern (225, 226, 325, 326) aufweist, welche durch eine elektrisch leitende Wand voneinander getrennt sind, wobei in der ersten Kammer (225, 226, 325, 326) der Energiespeicher (102, 202, 302) und der Signalgenerator (107, 207, 307, 407) angeordnet sind, und wobei in der zweiten Kammer (225, 226, 325, 326) die Koppelschnittstelle (106, 206, 306) angeordnet ist.

6. Signalerzeugungsvorrichtung (100, 200, 300, 400) nach Ansprüchen 2, 4, und 5, wobei die Schaltvorrichtung (222) in der ersten Kammer (225, 226, 325, 326) angeordnet ist und wobei die Lastnachbildungen (210, 211, 310, 311, 410, 411) und die Stromzangen (220, 221, 320, 321, 420, 421) in der zweiten Kammer (225, 226, 325, 326) angeordnet sind.

7. Signalerzeugungsvorrichtung (100, 200, 300, 400) nach Anspruch 6, wobei in der zweiten Kammer (225, 226, 325, 326) eine Anzahl entfernbarer elektrisch leitender Wände vorgesehen sind, wobei die Lastnachbildungen (210, 211, 310, 311, 410, 411) jeweils durch eine der entfernbaren elektrisch leitenden Wände voneinander getrennt sind.

8. Signalerzeugungsvorrichtung (100, 200, 300, 400) nach einem der vorherigen Ansprüche 5 bis 7, wobei das Gehäuse (101, 201) eine erste Schale aufweist, welche die erste Kammer (225, 226, 325, 326) bildet, und wobei das Gehäuse (101, 201) eine zweite Schale aufweist, welche die zweite Kammer (225, 226, 325, 326) bildet, wobei die zweite Schale die erste Kammer (225, 226, 325, 326) in einem montierten Zustand verschließt und wobei ein Deckel für die zweite Kammer (225, 226, 325, 326) vorgesehen ist.

9. Signalerzeugungsvorrichtung (100, 200, 300, 400) nach einem der vorherigen Ansprüche, wobei das Gehäuse (101, 201) eine Öffnung aufweist, welche ausgebildet ist, den Zugriff auf den Energiespeicher (102, 202, 302) zu ermöglichen, wobei eine entfernbare elektrisch leitende Abdeckung (330) vorgesehen ist, welche ausgebildet ist, die Öffnung zu verschließen.

10. Signalerzeugungsvorrichtung (100, 200, 300, 400) nach einem der vorherigen Ansprüche, wobei das Gehäuse (101, 201) eine Lüftungsöffnung aufweist, in welcher ein Wabenkamin (331) angeordnet ist, wobei die Lüftungsöffnung insbesondere derart angeordnet ist, dass ein Luftstrom zu dem Signalgenerator (107, 207, 307, 407) ermöglicht wird.

11. Signalerzeugungsvorrichtung (100, 200, 300, 400) nach einem der vorherigen Ansprüche, wobei die Datenschnittstelle (104, 204, 304) als lichtbasierte Schnittstelle ausgebildet ist, und/oder
wobei die Koppelschnittstelle (106, 206, 306) als elektrische Schnittstelle, insbesondere als leitungsbasierte Schnittstelle ausgebildet ist.

12. Messvorrichtung (450) für ein elektrisches System (470), aufweisend:
a) eine Signalerzeugungsvorrichtung (100, 200, 300, 400) nach einem der vorherigen Ansprüche, welche eingangsseitig mit dem elektrischen System (470) gekoppelt ist, und
b) eine Messeinrichtung (460), welche ausgangsseitig mit dem elektrischen System (470) gekoppelt ist und ausgebildet ist, elektrische Signale in dem elektrischen System (470) zu erfassen.

13. Messvorrichtung (450) nach Anspruch 12, wobei die Signalerzeugungsvorrichtung (100, 200, 300, 400) ausgebildet ist, mit einer Hochvoltseite des elektrischen Systems (470) gekoppelt zu werden und wobei die Messeinrichtung (460) ausgebildet ist, mit einer Niedervoltseite des elektrischen Systems (470) gekoppelt zu werden, wobei die Messeinrichtung (460) insbesondere eine Niedervolt-Lastnachbildung (210, 211, 310, 311, 410, 411) aufweist.

## Claims

1. Signal generating device (100, 200, 300, 400) for generating measurement signals (108, 208, 209) for electrical systems (470), comprising:
a) a casing (101, 201) comprising an electroconductive material,
b) an energy storage (102, 202, 302), which is arranged in the casing (101, 201),
c) a data interface (104, 204, 304), which is arranged on the casing (101, 201) and which is designed to receive signal data (105, 205),
d) a coupling interface (106, 206, 306), which is arranged on the casing (101, 201) and which can be coupled to the electrical system (470), and
e) a signal generator (107, 207, 307, 407), which is arranged in the casing (101, 201),
wherein the signal generating device (100, 200, 300, 400) comprises a number of load simulations (210, 211, 310, 311, 410, 411) which are arranged in the casing (101, 201) and which are electrically arranged between the coupling interface (106, 206, 306) and the signal generator (107, 207, 307, 407), **characterized in in that** the signal generator is coupled to the electrical energy storage (102, 202, 302) and the data interface (104, 204, 304) and the coupling interface (106, 206, 306), wherein the signal generator (107, 207, 307, 407) designed in such a way to generate the measurement signals on the basis of the signal data (105, 205) and to transmit them via the data interface (104, 204, 304) to the coupling interface (106, 206, 306), wherein the load simulations (210, 211, 310, 311, 410, 411) have a first input line (213, 215) and a second input line (212, 214) on the input side, wherein the first input line (212, 214) is coupled to the signal generator (107, 207, 307, 407) and wherein the second input line has a terminating resistor (218, 219, 318, 319, 418, 419), wherein the load simulations (210, 211, 310, 311, 410, 411) have an input switch (216, 217, 416, 417) which is designed to connect the first input line (212, 214) or the second input line (213, 215) in each case in a controlled manner.

2. Signal generating device (100, 200, 300, 400) according to claim 1, having a respective current clamp (220, 221, 320, 321, 420, 421) for each of the load simulations (210, 211, 310, 311, 410, 411), wherein the current clamps (220, 221, 320, 321, 420, 421) are arranged around the respective first input line (212, 214) and wherein the signal generator (107, 207, 307, 407) is coupled to the current clamps (220, 221, 320, 321, 420, 421) in order to couple the corresponding measurement signal (108, 208, 209) into the respective input line (213, 215).

3. Signal generating device (100, 200, 300, 400) according to claim 2 with a calibration unit which is coupled to the load simulations (210, 211, 310, 311, 410, 411) and the signal generator (107, 207, 307, 407) and which is designed to adjust a signal level for the respective measurement signal (108, 208, 209) in the signal generator (107, 207, 307, 407) in such a way that a predetermined nominal level is set in the corresponding load simulation (210, 211, 310, 311, 410, 411).

4. Signal generating device (100, 200, 300, 400) according to one of the preceding claims, having a switching facility (222) which is arranged between signal outputs of the signal generator (107, 207, 307, 407) and the load replicas (210, 211, 310, 311, 410, 411), the switching facility (222) being designed to couple the signal outputs to the load simulations (210, 211, 310, 311, 410, 411) in a controlled manner.

5. Signal generating device (100, 200, 300, 400) according to one of the preceding claims, wherein the casing (101, 201) comprises two chambers (225, 226, 325, 326) which are separated by an electroconductive wall, wherein the energy storage (102, 202, 302) and the signal generator (107, 207, 307, 407) are arranged in the first chamber (225, 226, 325, 326), and wherein the coupling interface (106, 206, 306) is arranged in the second chamber (225, 226, 325, 326).

6. Signal generating device (100, 200, 300, 400) according to claims 2, 4, and 5, wherein the switching facility (222) is arranged in the first chamber (225, 226, 325, 326), and wherein the load simulations (210, 211, 310, 311, 410, 411) and the current clamps (220, 221, 320, 321, 420, 421) are arranged in the second chamber (225, 226, 325, 326).

7. Signal generating device (100, 200, 300, 400) according to claim 6, wherein a number of removable electroconductive walls are provided in the second chamber (225, 226, 325, 326), wherein the load simulations (210, 211, 310, 311, 410, 411) are separated from each other by one of the removable electroconductive walls.

8. Signal generating device (100, 200, 300, 400) according to one of the preceding claims 5 to 7, wherein the casing (101, 201) comprises a first shell forming the first chamber (225, 226, 325, 326), and wherein the casing (101, 201) comprises a second shell forming the second chamber (225, 226, 325, 326), wherein the second shell closes the first chamber (225, 226, 325, 326) in an assembled state and wherein a cover is provided for the second chamber (225, 226, 325, 326).

9. Signal generating device (100, 200, 300, 400) according to one of the preceding claims, wherein the casing (101, 201) comprises an opening which is designed to allow access to the energy storage (102, 202, 302), wherein a removable electroconductive cover (330) is provided which is designed to close the opening.

10. Signal generating device (100, 200, 300, 400) according to any of the preceding claims, wherein the casing (101, 201) comprises a ventilation opening in which wave guides (331) are arranged, wherein the ventilation opening is arranged in such a particular way that an air flow to the signal generator (107, 207, 307, 407) is possible.

11. Signal generating device (100, 200, 300, 400) according to any of the preceding claims,
wherein the data interface (104, 204, 304) is designed as a light-based interface, and/or
wherein the coupling interface (106, 206, 306) is designed as an electrical interface, in particular as a line-based interface.

12. Measuring device (450) for an electrical system (470), comprising:
a) a signal generating device (100, 200, 300, 400) according to any of the preceding claims, which is coupled on the input side to the electrical system (470), and
b) a measuring device (460), which is coupled on the output side to the electrical system (470) and is designed to detect electrical signals in the electrical system (470).

13. Measuring device (450) according to claim 12, wherein the signal generating device (100, 200, 300, 400) is designed to be coupled to a high-voltage side of the electrical system (470) and wherein the measuring device (460) is designed to be coupled to a low-voltage side of the electrical system (470), wherein the measuring device (460) in particular has a low-voltage load simulation (210, 211, 310, 311, 410, 411).

## Revendications

1. Dispositif de génération de signaux (100, 200, 300, 400) pour générer des signaux de mesure (108, 208, 209) pour des systèmes électriques (470), comprenant :
a) un boîtier (101, 201) comprenant un matériau électriquement conducteur,
b) un accumulateur d'énergie (102, 202, 302) qui est disposé dans le boîtier (101, 201),
c) une interface de données (104, 204, 304) qui est disposée sur le boîtier (101, 201) et qui est conçue pour recevoir des données de signal (105, 205),
d) une interface de couplage (106, 206, 306) qui est disposée sur le boîtier (101, 201) et qui peut être couplée au système électrique (470), et
e) un générateur de signaux (107, 207, 307, 407) qui est disposé dans le boîtier (101, 201),
dans lequel le dispositif de génération de signal (100, 200, 300, 400) comprend un certain nombre de répliques de charge (210, 211, 310, 311, 410, 411) qui sont disposées dans le boîtier (101, 201) et qui sont disposées électriquement entre l'interface de couplage (106, 206, 306) et le générateur de signal (107, 207, 307, 407), **caractérisé en ce que en ce que** le générateur de signaux est couplé à l'accumulateur d'énergie électrique (102, 202, 302) et à l'interface de données (104, 204, 304) et à l'interface de couplage (106, 206, 306), le générateur de signaux (107, 207, 307, 407) étant conçu pour générer les signaux de mesure sur la base des données de signaux (105, 205) et pour les transmettre par l'intermédiaire de l'interface de données (104, 204, 304) interface de couplage (106, 206, 306), les répliques de charge (210, 211, 310, 311, 410, 411) présentant côté entrée une première ligne d'entrée (213, 215) et une deuxième ligne d'entrée (212, 214), la première ligne d'entrée (212, 214) étant reliée au générateur de signaux (107, 207, 307, 407) et la deuxième ligne d'entrée présentant une résistance de terminaison (218, 219, 318, 319, 418, 419), les répliques de charge (210, 211, 310, 311, 410, 411) présentant un commutateur d'entrée (216, 217, 416, 417) qui est conçu pour connecter respectivement de manière commandée la première ligne d'entrée (212, 214) ou la deuxième ligne d'entrée (213, 215).

2. Dispositif de génération de signaux (100, 200, 300, 400) selon la revendication 1, comprenant une pince de courant (220, 221, 320, 321, 420, 421) pour chacune des reproductions de charge (210, 211, 310, 311, 410, 411), les pinces de courant (220, 221, 320, 321, 420, 421) étant disposées autour de la première ligne d'entrée respective (212, 214) et dans lequel le générateur de signaux (107, 207, 307, 407) est couplé aux pinces de courant (220, 221, 320, 321, 420, 421) pour injecter le signal de mesure correspondant (108, 208, 209) dans la ligne d'entrée respective (213, 215).

3. Dispositif de génération de signaux (100, 200, 300, 400) selon la revendication 2 avec une unité de calibrage, qui est couplée aux reproductions de charge (210, 211, 310, 311, 410, 411) et au générateur de signaux (107, 207, 307, 407) et qui est conçue, de régler dans le générateur de signaux (107, 207, 307, 407) un niveau de signal pour le signal de mesure respectif (108, 208, 209) de telle sorte qu'un niveau de consigne prédéfini s'établisse dans la simulation de charge correspondante (210, 211, 310, 311, 410, 411).

4. Dispositif de génération de signaux (100, 200, 300, 400) selon l'une des revendications précédentes, comprenant un dispositif de commutation (222) disposé entre des sorties de signaux du générateur de signaux (107, 207, 307, 407) et les répliques de charge (210, 211, 310, 311, 410, 411), le dispositif de commutation (222) étant configuré pour coupler de manière commandée les sorties de signaux aux répliques de charge (210, 211, 310, 311, 410, 411).

5. Dispositif de génération de signaux (100, 200, 300, 400) selon l'une des revendications précédentes, dans lequel le boîtier (101, 201) comporte deux chambres (225, 226, 325, 326) séparées par une paroi électriquement conductrice, l'accumulateur d'énergie (102, 202, 302) et le générateur de signaux (107, 207, 307, 407) étant disposés dans la première chambre (225, 226, 325, 326), et l'interface de couplage (106, 206, 306) étant disposée dans la deuxième chambre (225, 226, 325, 326).

6. Dispositif de génération de signaux (100, 200, 300, 400) selon les revendications 2, 4 et 5, dans lequel le dispositif de commutation (222) est disposé dans la première chambre (225, 226, 325, 326) et dans lequel les répliques de charge (210, 211, 310, 311, 410, 411) et les pinces de courant (220, 221, 320, 321, 420, 421) sont disposées dans la deuxième chambre (225, 226, 325, 326).

7. Dispositif de génération de signaux (100, 200, 300, 400) selon la revendication 6, dans lequel un certain nombre de parois électriquement conductrices amovibles sont prévues dans la deuxième chambre (225, 226, 325, 326), dans lequel les répliques de charge (210, 211, 310, 311, 410, 411) sont chacune séparées les unes des autres par l'une des parois électriquement conductrices amovibles.

8. Dispositif de génération de signaux (100, 200, 300, 400) selon l'une quelconque des revendications précédentes 5 à 7, dans lequel le boîtier (101, 201) comprend une première coque formant la première chambre (225, 226, 325, 326), et dans lequel le boîtier (101, 201) comprend une deuxième coque, qui forme la deuxième chambre (225, 226, 325, 326), la deuxième coque fermant la première chambre (225, 226, 325, 326) dans un état monté et un couvercle étant prévu pour la deuxième chambre (225, 226, 325, 326).

9. Dispositif de génération de signaux (100, 200, 300, 400) selon l'une des revendications précédentes, dans lequel le boîtier (101, 201) présente une ouverture qui est conçue pour permettre l'accès à l'accumulateur d'énergie (102, 202, 302), dans lequel il est prévu un couvercle électriquement conducteur amovible (330) qui est conçu pour fermer l'ouverture.

10. Dispositif générateur de signaux (100, 200, 300, 400) selon l'une quelconque des revendications précédentes, dans lequel le boîtier (101, 201) comporte une ouverture de ventilation dans laquelle est disposée une cheminée en nid d'abeilles (331), l'ouverture de ventilation étant notamment disposée de manière à permettre un écoulement d'air vers le générateur de signaux (107, 207, 307, 407).

11. Dispositif de génération de signaux (100, 200, 300, 400) selon l'une des revendications précédentes, dans lequel l'interface de données (104, 204, 304) est conçue comme une interface basée sur la lumière, et/ou
l'interface de couplage (106, 206, 306) étant conçue comme une interface électrique, en particulier comme une interface basée sur les lignes.

12. Dispositif de mesure (450) pour un système électrique (470), comprenant :
a) un dispositif de génération de signaux (100, 200, 300, 400) selon l'une des revendications précédentes, qui est couplé côté entrée au système électrique (470), et
b) un dispositif de mesure (460) qui est couplé côté sortie au système électrique (470) et qui est conçu pour détecter des signaux électriques dans le système électrique (470).

13. Dispositif de mesure (450) selon la revendication 12, dans lequel le dispositif de génération de signaux (100, 200, 300, 400) est configuré pour être couplé à un côté haute tension du système électrique (470) et dans lequel le dispositif de mesure (460) est configuré pour être couplé à un côté basse tension du système électrique (470), le dispositif de mesure (460) comprenant en particulier une réplique de charge basse tension (210, 211, 310, 311, 410, 411).
